# EUROPEAN PATENT APPLICATION

(11) **EP 2 292 558 A1**
(43) Date of publication of application: **09.03.2011**
(21) Application number: 09766721.6
(22) Date of filing: 19.06.2009
(51) Int. Cl.: C01B 31/02, H01L 31/04, H01M 14/00

(54) **TITANIUM OXIDE COATED CARBON FIBER AND POROUS TITANIUM OXIDE COATED CARBON MATERIAL COMPOSITION**

(30) Priority: 20.06.2008 JP 2008162212; 20.06.2008 JP 2008162243
(71) Applicant: Osaka Gas Co., Ltd., Osaka 541-0046 (JP)
(72) Inventor: NISHINO, Hitoshi, Osaka-shi Osaka 541-0046 (JP); NISHIDA, Ryoichi, Osaka-shi Osaka 541-0046 (JP); MATSUYOSHI, Hiroaki, Osaka-shi Osaka 541-0046 (JP); SAKAMOTO, Hiroki, Osaka-shi Osaka 541-0046 (JP); TOMITA, Haruo, Osaka-shi Osaka 541-0046 (JP); HAYAMA, Hidekazu, Kyoto-shi Kyoto 600-8813 (JP); TABUCHI, Minoru, Kyoto-shi Kyoto 600-8813 (JP); ICHIMURA, Nobuko, Kyoto-shi Kyoto 600-8813 (JP); DEGUCHI, Tomoe, Kyoto-shi Kyoto 600-8813 (JP)
(74) Representative: Müller-Boré & Partner Patentanwälte
(86) International application number: PCT/JP2009/061218
(87) International publication number: WO 2009/154273

(57) **Abstract**

With a view to realizing a titanium oxide composite that has a large surface area and that enables efficient transfer of electrons by covering a surface of rod-like or fibrous carbon with a covering layer comprising titanium oxide particles connected to one another, an object of the invention is to develop a material useful as an active material for dye-sensitized solar cells, and a process for producing the material; a porous titanium oxide-covered carbon material composition, and a process for producing the composition; and a photoelectric conversion element comprising the titanium oxide-covered carbon material or porous titanium oxide-covered carbon material composition.

## Description

### [Technical Field]

The present invention relates to a titanium oxide-covered carbon material for use in photoelectric conversion elements, such as dye-sensitized solar cells, and a process for producing the material; a porous titanium oxide-covered carbon material composition for use in photoelectric conversion elements, such as dye-sensitized solar cells, and a process for producing the composition; and a photoelectric conversion element comprising the titanium oxide-covered carbon material or porous titanium oxide-covered carbon material composition.

### [Background Art]

Solar cells have attracted attention as environmentally friendly power-generation devices. Silicon-based semiconductors utilizing p-n junctions are widely known as such solar cells. However, the manufacture of silicon-based solar cells requires high vacuum and high temperatures, making it difficult to reduce costs, preventing practical use of silicon-based solar cells.

With an expectation for the development of lower-cost solar cells, Graetzel et al. reported dye-sensitized solar cells wherein titanium dioxide or the like that is modified with a dye is used as an active electrode (see Patent Literature 1). Dye-sensitized solar cells have attracted attention as solar cells that can be readily manufactured at low cost.

However, further improvement in the performance of dye-sensitized solar cells is presently required for dye-sensitized solar cells, for example, in terms of the electron conduction of titanium oxide used as an active electrode.

Titanium oxide nanoparticles are generally known to exhibit high performance as an active electrode. The use of nanoparticles is intended to provide a large area for a dye that is adsorbed on the titanium oxide, thereby efficiently absorbing incident light. However, the use of nanoparticles involves a trade-off in that the presence of an interface between the particles precludes efficient transfer of charge-separated electrons. Thus, there has been a need for titanium oxide that has a large surface area on which a dye can be adsorbed, and that enables efficient transfer of electrons, for use as an active electrode for dye-sensitized solar cells.

In view of this problem, cases where titanium oxide in the form of nanowires is used as active electrodes have been reported (see Non-Patent Literatures 1 and 2). However, because these nanowires are only composed of titanium oxide, which is a semiconductor, they do not possess sufficient conductivities, and thus require more efficient electron transfer.

Patent Literature 2 investigates an active electrode wherein a titanium oxide coating is formed on carbon tubes whose lengthwise direction is arranged substantially perpendicular to the film-formation surface of a substrate. This is done in order to improve the conductivity of a current flowing in the lamination direction of films, thereby providing increased electron conductivity in the titanium oxide and efficient transfer of electrons from the titanium oxide to the electrode. However, the active electrode of Patent Document 2 has the problem of an increased leakage current, possibly due to the difficulty in forming a uniform titanium oxide coating.

Patent Literature 3 teaches mixing an active material, i.e., oxide particles, with carbon nanotubes. However, if the carbon nanotubes are not sufficiently coated with the active material oxide, the leakage current will increase, resulting in the problem of reduced power-generation efficiency.

### [Citation List]

### [Patent Literature]

[PTL 1] Japanese Examined Patent Publication No. 1996-15097
[PTL 2] Japanese Unexamined Patent Publication No. 2004-319661
[PTL 3] Japanese Unexamined Patent Publication No. 2003-123860

### [Non-patent Literature]

[NPL 1] Abstracts of the Meeting of the Electrochemical Society of Japan, 2001, the 68th, p. 112
[NPL 2] Abstracts of the Autumn Meeting of the Electrochemical Society of Japan, 2002, p. 138

### [Summary of Invention]

### [Technical Problem]

With a view to realizing a titanium oxide composite that has a large surface area and that enables efficient transfer of electrons, an object of the invention is to develop a titanium oxide-covered carbon material that is useful as an active material for dye-sensitized solar cells, and a process for producing the material; a porous titanium oxide-covered carbon material composition that is useful as an active material for dye-sensitized solar cells, and a process for producing the composition; and a photoelectric conversion element comprising the titanium oxide-covered carbon material or porous titanium oxide-covered carbon material composition.

### [Solution to Problem]

The present inventors conducted extensive research in view of the foregoing object. Consequently, the present inventors found that a titanium oxide composite that has a large surface area and that enables efficient transfer of electrons can be provided by covering the surface of rod-like or fibrous carbon with a covering layer comprising titanium oxide particles connected to one another. The present inventors also found that a mixture of the titanium oxide composite and titanium oxide particles is preferable as an active material for dye-sensitized solar cells, because the mixture improves photoelectric conversion efficiency. The invention has been accomplished based on these findings. Features of the invention are as summarized below.

Item 1. A rod-like or fibrous titanium oxide-covered carbon material comprising
(1a) rod-like or fibrous carbon, and
(1b) titanium oxide particles,
wherein a surface of the carbon (1a) is covered with a covering layer comprising the titanium oxide particles (1b) connected to one another.

Item 2. The rod-like or fibrous titanium oxide-covered carbon material according to Claim 1, wherein 70 to 100% of the surface of the carbon (1a) is covered with the titanium oxide particles (1b), as measured by electron microscopic observation.

Item 3. The rod-like or fibrous titanium oxide-covered carbon material according to Claim 1 or 2, wherein an element ratio (C/Ti) of carbon and titanium on the surface of the rod-like or fibrous titanium oxide-covered carbon material is 0/100 to 70/30 (atomic ratio), as measured by X-ray photoelectron spectroscopic analysis.

Item 4. The rod-like or fibrous titanium oxide-covered carbon material according to any one of claims 1 to 3, wherein the rod-like or fibrous titanium oxide-covered carbon material has a powder resistance of 10 Ω·m or less at a pressure of 10 MPa.

Item 5. The titanium oxide-covered carbon material according to any one of claims 1 to 4, wherein the titanium oxide-covered carbon material has a mean diameter of 5 to 500 nm perpendicular to a long axis, a mean long-axis length of 0.1 to 1,000 µm, and a mean aspect ratio of 3 to 200,000.

Item 6. The titanium oxide-covered carbon material according to any one of claims 1 to 5, wherein the titanium oxide particles (1b) have a mean particle size of 1 to 200 nm.

Item 7. The titanium oxide-covered carbon material according to any one of claims 1 to 6, wherein the covering layer has a thickness of 2 to 500 nm.

Item 8. The titanium oxide-covered carbon material according to any one of claims 1 to 7, wherein the carbon (1a) has a mean diameter of 1 to 100 nm perpendicular to a long axis, a mean long-axis length of 0.1 to 1,000 µm, and a mean aspect ratio of 5 to 1,000,000.

Item 9. The titanium oxide-covered carbon material according to any one of claims 1 to 8, wherein the titanium oxide-covered carbon material has a specific surface area of 50 m²/g or more.

Item 10. The titanium oxide-covered carbon material according to any one of claims 1 to 9, wherein the rod-like or fibrous carbon (1a) is nanoscale carbon tubes.

Item 11. The titanium oxide-covered carbon material according to any one of claims 1 to 10, wherein the titanium oxide particles (1b) comprise at least one member selected from the group consisting of anatase titanium oxide, rutile titanium oxide, and brookite titanium oxide.

Item 12. A process for producing the titanium oxide-covered carbon material of any one of claims 1 to 11, comprising the step of
forming a covering layer comprising titanium oxide particles (1b) connected to one another on a surface of rod-like or fibrous carbon (1a) by performing a precipitation reaction from a fluorotitanate complex.

Item 13. A porous titanium oxide-covered carbon material composition being a mixture of:
(1) the rod-like or fibrous titanium oxide-covered carbon material of any one of claims 1 to 11; and
(2) titanium oxide particles.

Item 14. The porous titanium oxide-covered carbon material composition according to claim 13, wherein the mixture comprises 0.1 to 90 wt% of the titanium oxide-covered carbon material (1) and 10 to 99.9 wt% of the titanium oxide particles (2).

Item 15. The porous titanium oxide-covered carbon material composition according to claim 13 or 14, wherein the titanium oxide particles (2) have a mean particle size of 1 to 500 nm.

Item 16. The porous titanium oxide-covered carbon material composition according to any one of claims 13 to 15, wherein the porous titanium oxide-covered carbon material composition has a specific surface area of 30 m²/g or more.

Item 17. The porous titanium oxide-covered carbon material composition according to any one of claims 13 to 16, wherein the titanium oxide particles (2) comprise at least one member selected from the group consisting of anatase titanium oxide, rutile titanium oxide, and brookite titanium oxide.

Item 18. The porous titanium oxide-covered carbon material composition according to any one of claims 13 to 17, comprising 40 to 100% of pores having a pore size of 5 to 50 nm of a total volume of pores.

Item 19. A process for producing the porous titanium oxide-covered carbon material composition of any one of claims 13 to 18, comprising the steps of:
(A) forming a covering layer comprising titanium oxide particles (1b) connected to one another on a surface of rod-like or fibrous carbon (1a) by performing a precipitation reaction from a fluorotitanate complex, thereby preparing a titanium oxide-covered carbon material (1); and
(B) mixing the titanium oxide-covered carbon material (1) obtained in Step (A) with titanium oxide particles (2).

Item 20. A photoelectric conversion element comprising a dye deposited on a surface of an active material, the active material comprising the titanium oxide-covered carbon material of any one of claims 1 to 11, or the porous titanium oxide-covered carbon material composition of any one of claims 13 to 18.

### [Advantageous Effects of Invention]

The invention provides a titanium oxide-covered carbon fiber that has a large surface area and enables efficient transfer of electrons, and a process for producing the titanium oxide-covered carbon fiber; a porous titanium oxide-covered carbon material composition, and a process for producing the composition; and a photoelectric conversion element comprising the titanium oxide-covered carbon material or porous titanium oxide-covered carbon material composition.

### [Brief Description of Drawings]

Fig. 1 is a transmission electron microscope (TEM) photograph of a single fiber of the iron-carbon composite forming the carbonaceous material obtained in Example 1 of Japanese Unexamined Patent Publication No. 2002-338220.
Fig. 2 is a transmission electron microscope (TEM) photograph showing how the iron-carbon composite is present in the carbonaceous material obtained in Example 1 of Japanese Unexamined Patent Publication No. 2002-338220.
Fig. 3 is a transmission electron microscope (TEM) photograph of a cross section of a single fiber of the iron-carbon composite obtained in Example 1 of Japanese Unexamined Patent Publication No. 2002-338220.
   The black triangles (▲) shown in the photograph of Fig. 3 represent points of EDX measurement for composition analysis.
Fig. 4 shows schematic diagrams of TEM images of carbon tubes; Fig. 4(a-1) is a schematic diagram of the TEM image of a cylindrical nanoflake carbon tube, and Fig. 4(a-2) is a schematic diagram of the TEM image of a nested multi-walled carbon nanotube.
Fig. 5 is a scanning electron microscope (SEM) photograph showing the surface morphology of a titanium oxide-covered carbon material of the invention.
Fig. 6 is a schematic diagram illustrating the transfer of electrons in the titanium oxide-covered carbon material of the invention, which is covered with a covering layer comprising titanium oxide particles connected to one another.
Fig. 7 is a scanning electron microscope (SEM) photograph showing the surface morphology of a titanium oxide-covered carbon material that is not sufficiently covered with a covering layer comprising titanium oxide particles connected to one another.
Fig. 8 is a schematic diagram illustrating the transfer of electrons in the titanium oxide-covered carbon material that is not sufficiently covered with a covering layer comprising titanium oxide particles connected to one another.
Fig. 9 is a scanning electron microscope (SEM) photograph showing the surface morphology of the porous titanium oxide-covered carbon material composition of the invention, which comprises titanium oxide particles and a titanium oxide-covered carbon material that is covered with a covering layer comprising titanium oxide particles connected to one another.
Fig. 10 is a transmission electron microscope (TEM) photograph of the titanium oxide-covered carbon material of Example 1.

### [Description of Embodiments]

### 1. Titanium Oxide-Covered Carbon Material (1)

The titanium oxide-covered carbon material (1) of the invention comprises rod-like or fibrous carbon (1a), and titanium oxide particles (1b), wherein a surface of the carbon (1a) is covered with a covering layer comprising the titanium oxide particles (1b) connected to one another.

### 1-1. Rod-Like or Fibrous Carbon (1a)

There are no limitations on the rod-like or fibrous carbon (1a) used in the invention; however, nanoscale carbon tubes are preferably used as the carbon (1a). The nanoscale carbon tubes are preferably formed of a conductive material.

In order to subsequently enable the production of a titanium oxide-covered carbon material (1) that is as fine as possible, has a large surface area, and wherein titanium oxide particles (1b) are connected over a long length, the rod-like or fibrous carbon (1a) preferably has a mean diameter of about 1 to 100 nm perpendicular to the long axis, a mean long-axis length of about 0.1 to 1,000 µm, and a mean aspect ratio (mean long-axis length/mean diameter perpendicular to the long axis) of about 5 to 1,000,000; more preferably a mean diameter of about 1 to 100 nm perpendicular to the long axis, a mean long-axis length of about 0.1 to 1,000 µm, and a mean aspect ratio (mean long-axis length/mean diameter perpendicular to the long axis) of about 5 to 10,000; and still more preferably a mean diameter of about 1 to 50 nm perpendicular to the long axis, a mean long-axis length of about 1 to 50 µm, and a mean aspect ratio of about 10 to 10,000. The mean diameter perpendicular to the long axis, the mean long-axis length, and the mean aspect ratio can be measured by, e.g., electron microscopic (SEM or TEM) observation with a magnification over 10,000x.

### Nanoscale Carbon Tubes

The nanoscale carbon tubes for use in the present invention refer to carbon tubes with nanoscale diameters, which may encapsulate iron or the like in their interiors.

Examples of such nanoscale carbon tubes include
(i) single-walled carbon nanotubes or multi-walled carbon nanotubes;
(ii) amorphous nanoscale carbon tubes developed by the present applicant;
(III) nanoflake carbon tubes;
(iv) iron-carbon composites each composed of (a) a carbon tube selected from the group consisting of nanoflake carbon tubes and nested multi-walled carbon nanotubes, and (b) iron carbide or iron, wherein the iron carbide or iron (b) fills 10 to 90% of the internal space of the carbon tube (a); and
(v) a mixture of two or more thereof.

### <Carbon Nanotubes>

The carbon nanotubes (I) are hollow carbon substances in which graphite sheets (i.e., the carbon atom layers of graphite structures or graphene sheets) are rolled to form tubes, and have a diameter in the nanoscale range, and walls thereof have a graphite structure. The carbon nanotubes (I) in which the wall is made of a single graphite sheet closed to form a tube are called single-walled carbon nanotubes, while those comprising a plurality of graphite sheets each closed to form a tube and nested in one another are called nested multi-walled carbon nanotubes. In the present invention, both single-walled carbon nanotubes and nested multi-walled carbon nanotubes can be used.

The single-walled carbon nanotubes usable in the invention preferably have a mean diameter of about 1 to 10 nm perpendicular to the long axis, a mean long-axis length of about 0.1 to 500 µm, and a mean aspect ratio of about 10 to 500,000; more preferably have a mean diameter of about 1 to 10 nm perpendicular to the long axis, a mean long-axis length of about 0.1 to 500 µm, and a mean aspect ratio of about 10 to 50,000; still more preferably have a mean diameter of about 1 to 5 nm perpendicular to the long axis, a mean long-axis length of about 1 to 100 µm, and a mean aspect ratio of about 15 to 30,000; and even more preferably have a mean diameter of about 1 to 2 nm perpendicular to the long axis, a mean long-axis length of about 1 to 20 µm, and a mean aspect ratio of about 20 to 20,000.

The nested multiwalled carbon nanotubes usable in the invention preferably have a mean diameter of about 1 to 100 nm perpendicular to the long axis, a mean long-axis length of about 0.1 to 500 µm, and a mean aspect ratio of about 1 to 500,000; more preferably have a mean diameter of about 1 to 100 nm perpendicular to the long axis, a mean long-axis length of about 0.1 to 500 µm, and a mean aspect ratio of about 5 to 10,000; still more preferably have a mean diameter of about 1 to 50 nm perpendicular to the long axis, a mean long-axis length of about 1 to 100 µm, and a mean aspect ratio of about 10 to 10,000; and even more preferably have a mean diameter of about 1 to 40 nm perpendicular to the long axis, a mean long-axis length of about 1 to 20 µm, and a mean aspect ratio of about 10 to 10,000.

### <Amorphous Nanoscale Carbon Tubes>

The amorphous nanoscale carbon tubes (II) are nanoscale carbon tubes of an amorphous structure that are disclosed in WO 00/40509 (Japanese Patent No. 3355442), have a main skeleton consisting of carbon, and have a diameter of 0.1 to 1,000 nm. The amorphous nanoscale carbon tubes (II) have an interlayer spacing (d002) between hexagonal carbon layers of 3.54 Å or more, and preferably 3.7 Å or more, a diffraction angle (2θ) of 25.1 degrees or less, and preferably 24.1 degrees or less, and a 2θ band half-width of 3.2 degrees or more, and preferably 7.0 degrees or more, as determined by X-ray diffractometry (incident X-ray: Cuκα).

The amorphous nanoscale carbon tubes (II) are obtained by an excitation treatment of a heat-decomposable resin having a decomposition temperature of 200 to 900°C, such as, for example, polytetrafluoroethylene, polyvinylidene chloride, polyvinylidene fluoride, or polyvinyl alcohol, in the presence of a catalyst comprising at least one chloride of a metal such as magnesium, iron, cobalt, or nickel.

The heat-decomposable resin as the starting material may be in any form, such as films or sheets, powders, or masses. For example, to obtain a carbon material comprising a thin layer of amorphous nanoscale carbon tubes formed on a substrate, a heat-decomposable resin may be applied to or mounted on a substrate and then subjected to an excitation treatment under suitable conditions.

The excitation treatment can be carried out by, e.g., heating in an inert atmosphere at a temperature that is within the range of about 450 to 1,800°C and is not lower than the heat decomposition temperature of the starting material; or by plasma-treating at a temperature that is within the range from room temperature to about 3,000°C and is not lower than the heat decomposition temperature of the starting material.

The amorphous nanoscale carbon tubes (II) usable in the present invention are nanoscale carbon tubes with an amorphous structure, which have a hollow straight shape and highly controlled pores. The tubes usually have a cylindrical or rectangular prism shape, and most of the tubes have at least one uncapped (open) end. In the case where tubes with closed ends are present, most of these tubes have flat ends.

The amorphous nanoscale carbon tubes (II) preferably have a mean outside diameter of about 1 to 100 nm, a mean length of about 0.1 to 1,000 µm, and a mean aspect ratio of about 1 to 1,000,000; more preferably a mean outside diameter of about 1 to 100 nm, a mean length of about 0.1 to 1,000 µm, and a mean aspect ratio of about 5 to 10,000; and still more preferably a mean outside diameter of about 1 to 50 µm, a mean length of about 1 to 50 µm, and a mean aspect ratio of about 10 to 10,000.

As used herein, the term "amorphous structure" means a carbonaceous structure consisting of disordered hexagonal carbon layers, in which a large number of graphene sheets are irregularly disposed, as opposed to a graphitic structure consisting of continuous carbon layers of regularly disposed carbon atoms. In view of an image through a transmission electron microscope, which is a typical analytical means, the dimension in the planar direction of the hexagonal carbon layers of the amorphous nanoscale carbon tubes (II) for use in the present invention is smaller than the diameter of the carbon tubes (II). Thus, since the wall of the amorphous nanoscale carbon tubes (II) does not have a graphite structure, but has an amorphous structure consisting of a large number of irregularly distributed minute graphene sheets (hexagonal carbon layers), the outermost hexagonal carbon layer is not continuous but discontinuous over the entire length in the lengthwise direction of each tube.
The hexagonal carbon layers constituting the outermost layer have a length of less than 20 nm, and preferably less than 5 nm.

Generally, amorphous carbon causes no X-ray diffraction but shows a broad reflection. In a graphitic structure, hexagonal carbon layers are regularly stacked on top of one another, so that spacings between the hexagonal carbon layers (d₀₀₂) are narrow. Accordingly, the broad reflection shifts towards the high-angle side (2θ) and gradually narrows (has a smaller half-width of the 2θ band). As a result, the reflection can be observed as a d₀₀₂ diffraction band (d₀₀₂=3.354 Å when the layers are regularly stacked on top of one another with a graphitic configuration).

In contrast, an amorphous structure generally does not cause X-ray diffraction as described above, but partially shows very weak coherent scattering. As determined by X-ray diffractometry (incident X-ray: CuKα) using a diffractometer, the theoretical crystallographic characteristics of the amorphous nanoscale carbon tubes (II) for use in the invention are defined as follows: the spacings between hexagonal carbon layers (d₀₀₂) are 3.54 Å or more, and preferably 3.7 Å or more; the diffraction angle (2θ) is 25.1 degrees or less, and preferably 24.1 degrees or less; and the 2θ band half-width is 3.2 degrees or more, and preferably 7.0 degrees or more.

Typically, the amorphous nanoscale carbon tubes (II) usable in the present invention have a diffraction angle (2θ) determined by X-ray diffraction of 18.9 to 22.6 degrees, spacings between hexagonal carbon layers (d₀₀₂) of 3.9 to 4.7 Å, and a 2θ band half-width of 7.6 to 8.2 degrees.

The term "straight" used to describe the shape of the amorphous nanoscale carbon tubes (II) usable in the present invention refers to shape characteristics such that the ratio L/Lₒ is at least 0.9, wherein L is the length of the image of an amorphous nanoscale carbon tube (II) as measured by a transmission electron microscope, and Lₒ is the length of the amorphous nanoscale carbon tube (II) as extended linearly.

Such amorphous nanoscale carbon tubes (II) each have a wall with an amorphous structure consisting of a plurality of minute hexagonal carbon layers (graphene sheets) oriented in various directions, and have the advantage of excellent compatibility with resins, presumably because they have active points due to the spacings between the hexagonal carbon layers.

### <Iron-Carbon Composites>

The iron-carbon composites (IV) usable in the invention are disclosed in Japanese Unexamined Patent Publication No. 2002-338220 (Japanese Patent No. 3,569,806), and each composed of (a) a carbon tube selected from the group consisting of nanoflake carbon tubes and nested multi-walled carbon nanotubes, and (b) iron carbide or iron, wherein the iron carbide or iron (b) fills 10 to 90% of the internal space of the carbon tube (a). Specifically, the iron-carbon composites have a feature in that the iron carbide or iron does not fill 100% of the internal space of the tube, but fills 10 to 90% of (i.e., partially fills) the space. The wall of the nanoflake carbon tube has a patchwork-like or papier-mache-like form.

In this description and the appended claims, the term "nanoflake carbon tube" refers to a carbon tube composed of a group of a plurality of (usually many) flake-like graphite sheets formed into a patchwork- or papier-mache-like structure.

Such iron-carbon composites (IV) can be produced according to a method described in Japanese Unexamined Patent Publication No. 2002-338220, the method comprising:
(1) heating an iron halide to 600 to 900°C in a reaction furnace in which the pressure has been adjusted to 10⁻⁵ Pa to 200 kPa in an inert gas atmosphere and the oxygen concentration in the reaction furnace has been adjusted such that the ratio B/A is between 1×10⁻¹⁰ and 1×10⁻¹ wherein A is the reaction furnace volume (liters) and B is the amount of oxygen (Ncc), and
(2) introducing an inert gas into the reaction furnace, and at a pressure of between 10⁻⁵ Pa and 200 kPa, introducing thereto a pyrolyzable carbon source and performing a heat treatment at 600 to 900°C.

The term "Ncc" herein, which is the unit of the oxygen quantity B, means the volume (cc) of the gas in its normal state at 25°C.

The iron-carbon composites (IV) each comprise (a) a carbon tube selected from the group consisting of nanoflake carbon tubes and nested multi-walled carbon nanotubes and (b) iron carbide or iron. Rather than substantially all the internal space (i.e., the spaces defined by the tube walls) of the carbon tube being filled, a part of the space, more specifically about 10 to 90%, preferably about 30 to 80%, and more preferably about 40 to 70%, of the space is filled with iron carbide or iron.

In the iron-carbon composites (IV) usable in the invention, as described in Japanese Unexamined Patent Publication No. 2002-338220, the carbon portion becomes nanoflake carbon tubes when cooling is carried out at a specific rate after steps (1) and (2), or becomes nested multi-walled carbon nanotubes when a heat treatment in an inert gas atmosphere and cooling at a specific rate are carried out after steps (1) and (2).

### <(a-1) Nanoflake Carbon Tubes>

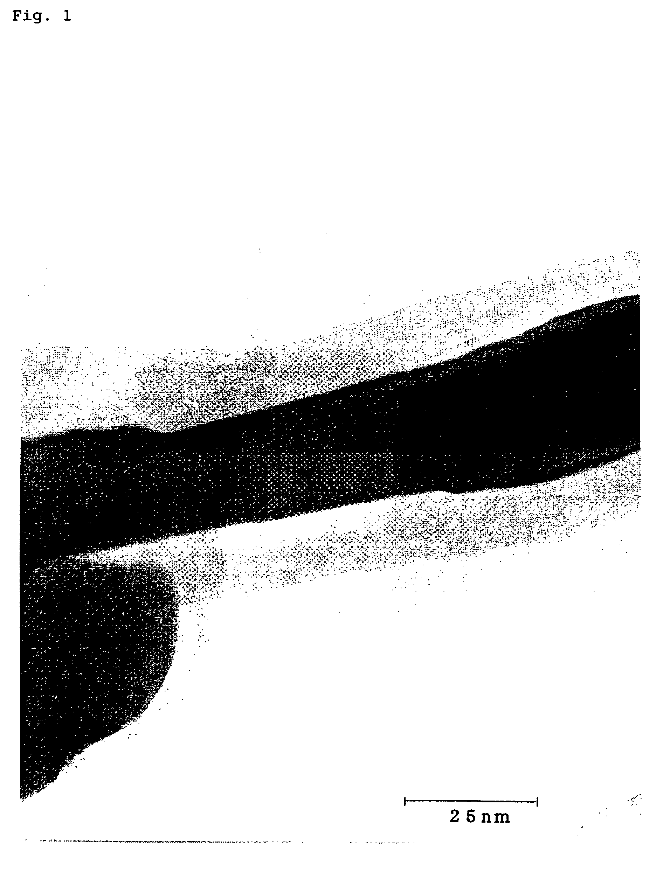

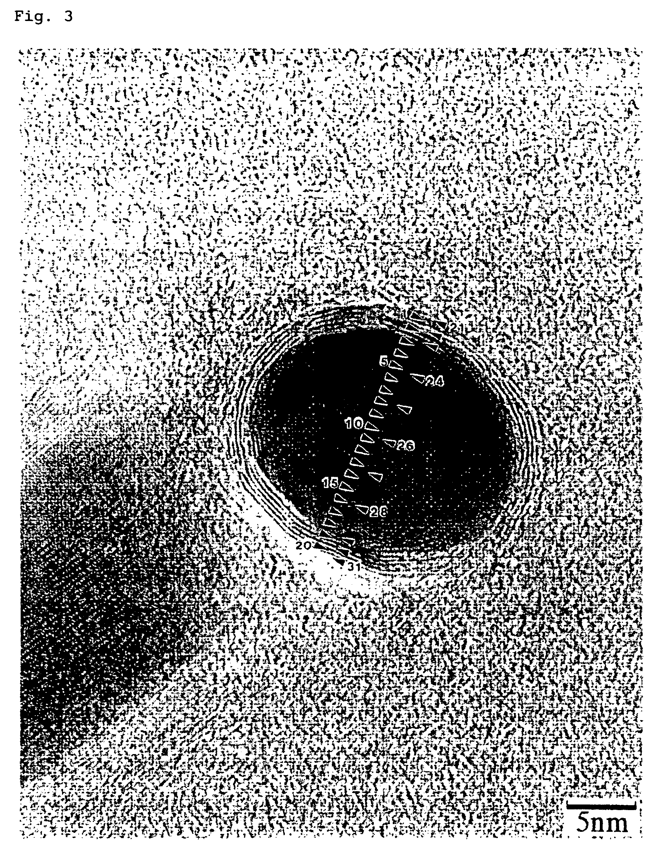

The iron-carbon composites (IV) usable in the invention comprising nanoflake carbon tubes (a-1) and iron carbide or iron (b), are typically cylindrical in shape. Fig. 3 shows a transmission electron microscope (TEM) photograph of a cross section substantially perpendicular to the lengthwise direction of such a cylindrical iron-carbon composite (obtained in Example 1 of Japanese Unexamined Patent Publication No. 2002-338220). Fig. 1 shows a TEM photograph of the side thereof.

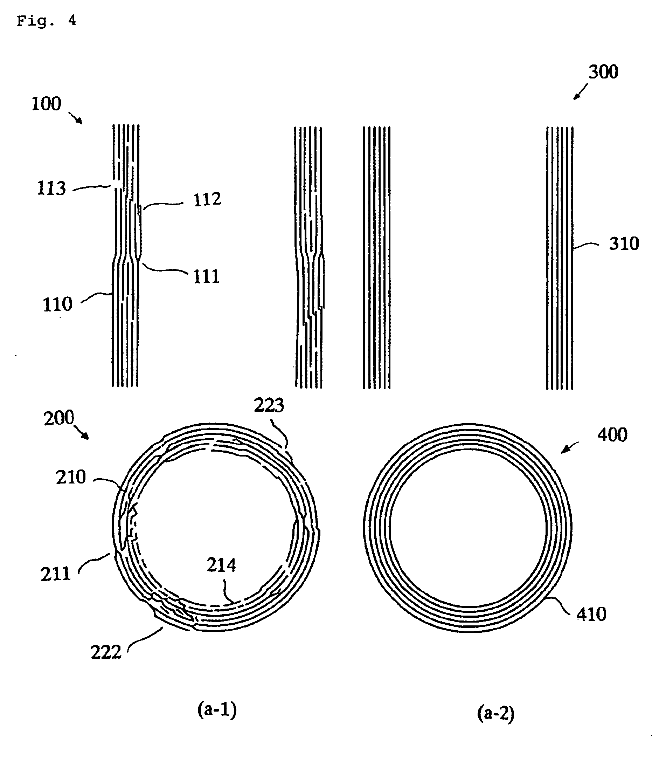

Fig. 4 (a-1) is a schematic diagram of a TEM image of such a cylindrical nanoflake carbon tube. In Fig. 4 (a-1), 100 schematically shows a TEM image of the lengthwise direction of the nanoflake carbon tube, while 200 schematically shows a TEM image of a cross section substantially perpendicular to the lengthwise direction of the nanoflake carbon tube.

The nanoflake carbon tubes (a-1) constituting the iron-carbon composites (IV) usable in the invention typically have a hollow cylindrical shape. When the cross section of one of the nanoflake carbon tubes is viewed by TEM, it can be seen that arc-shaped graphene sheet images are concentrically grouped and individual graphene sheet images form discontinuous rings; and when the lengthwise direction of the nanoflake carbon tube is viewed by TEM, approximately straight-shaped graphene sheet images are arranged in layers substantially parallel to the lengthwise direction, and the individual graphene sheet images are not continuous over the entire length of the carbon tube, and are instead broken in places.

More specifically, as is clear from Fig. 3 and 200 in Fig. 4 (a-1), when a cross section perpendicular to the lengthwise direction is observed by TEM, each nanoflake carbon tube (a-1) constituting the iron-carbon composites (IV) usable in the invention has such a structure that numerous arc-shaped graphene sheet images are grouped concentrically (in a multi-walled tubular form), but as indicated by, e.g., 210 and 214, the individual graphene sheet images do not form completely closed, continuous rings, and instead form non-continuous rings that are broken in places. Some of the graphene sheet images may be branched, as indicated by 211. At the non-continuous areas, a plurality of arc-shaped TEM images that make up one non-continuous ring may be such that the layer structure is partially disturbed as indicated by 222 in Fig. 4 (a-1), or there may be gaps between adjacent graphene sheet images as indicated by 223. However, the numerous arc-shaped graphene sheet images observed by TEM, taken together, form a multi-walled tube structure.

As is clear from Fig. 1 and 100 in Fig. 4 (a-1), when the nanoflake carbon tube (a-1) is viewed in the lengthwise direction by TEM, it can be seen that numerous substantially linear graphene sheet images are arranged in layers substantially parallel to the lengthwise direction of each iron-carbon composite (IV) for use in the invention, but the individual graphene sheet images 110 are not continuous over the entire length of the iron-carbon composite (IV), and are instead broken in places. Some of the graphene sheet images may be branched, as indicated by 111 in Fig. 4 (a-1). Among the TEM images arranged in layers at the non-continuous points, the TEM image of a non-continuous layer may at least partially overlap an adjacent graphene sheet image as indicated by 112 in Fig. 4 (a-1), or it may be slightly apart from an adjacent graphene sheet image as indicated by 113, but the numerous substantially linear TEM images, taken together, form a multi-walled structure.

Such a structure of the nanoflake carbon tubes (a-1) usable in the invention greatly differs from that of conventional multi-walled carbon nanotubes. Specifically, a nested multi-walled carbon nanotube (a-2) has a tube structure (a concentric cylindrical or nested structure) in which, as indicated by 400 in Fig. 4 (a-2), the TEM image of a cross section perpendicular to the lengthwise direction thereof is in a concentric circular form comprising substantially perfectly circular TEM images as indicated by 410, and as indicated by 300 in Fig. 4 (a-2), linear graphene sheet images 310 which are continuous over the entire length in the lengthwise direction are arranged in parallel.

In view of the above, although the details are not yet fully clarified, the nanoflake carbon tubes (a-1) constituting the iron-carbon composites (IV) usable in the invention appear to have such a structure that numerous flaky graphene sheets are stacked in a patchwork- or papier-mache-like structure and, taken together, form a tube.

The iron-carbon composites (IV) usable in the invention, each of which comprises a nanoflake carbon tube (a-1) and iron carbide or iron (b) contained in the internal space of the tube, greatly differ in carbon tube structure from the composites disclosed in Japanese Patent No. 2546114 in which a metal is contained in the internal space of nested multi-walled carbon nanotubes (a-2).

When the nanoflake carbon tubes (a-1) of the iron-carbon composites (IV) usable in the invention are observed by TEM, with respect to the numerous substantially linear graphene sheet images arranged in the lengthwise direction thereof, the length of the individual graphene sheet images is usually about 2 to 500 nm, and particularly about 10 to 100 nm. Specifically, as indicated by 100 in Fig. 4 (a-1), numerous TEM images of the substantially linear graphene sheets indicated by 110 are grouped together to constitute a TEM image of the wall of a nanoflake carbon tube (a-1), and the length of the individual substantially linear graphene sheet images is usually about 2 to 500 nm, and preferably about 10 to 100 nm.

As described above, in the iron-carbon composite (IV), the outermost layer of the wall of each nanoflake carbon tube (a-1) is formed from discontinuous graphene sheets that do not continue over the entire length in the lengthwise direction of the tube, and the outermost hexagonal carbon layer has a length of about 2 to 500 nm, and preferably about 10 to 100 nm.

While the carbon portion, i.e., the wall of each nanoflake carbon tube (a-1) in the iron-carbon composites (IV) usable in the invention, is composed of numerous flake-like graphene sheets which are arranged in the lengthwise direction to form a tube as a whole as discussed above, the wall has a graphitic structure in which the mean spacing between the hexagonal carbon layers (d₀₀₂) is 0.34 nm or less, as determined by X-ray diffractometry.

The thickness of the wall of each nanoflake carbon tube (a-1) of the iron-carbon composites (IV) usable in the invention is 49 nm or less, preferably about 0.1 to 20 nm, and more preferably about 1 to 10 nm, and is substantially uniform over the entire length.

### <(a-2) Nested Multi-Walled Carbon Nanotubes>

By carrying out Steps (1) and (2) as mentioned above and then performing a specific heating step, the carbon tubes in the obtained iron-carbon composites (IV) become nested multi-walled carbon nanotubes (a-2).

The nested multi-walled carbon nanotubes (a-2) thus obtained have a tube structure (a concentric cylindrical or nested structure) in which, as indicated by 400 in Fig. 4 (a-2), the TEM image of a cross section perpendicular to the lengthwise direction thereof is in a concentric circular form comprising substantially perfect circles, and graphene sheet images which are continuous over the entire length in the lengthwise direction are arranged in parallel.

The carbon portion, i.e., the wall of each nested multi-walled carbon tube (a-2) of the iron-carbon composites (IV) usable in the invention, is of a graphitic structure in which the mean spacing between the hexagonal carbon layers (d₀₀₂) is 0.34 nm or less, as determined by X-ray diffractometry.

The thickness of the wall of the nested multi-walled carbon nanotubes (a-2) of the iron-carbon composites (IV) usable in the invention is 49 nm or less, preferably about 0.1 to 20 nm, and more preferably about 1 to 10 nm, and is substantially uniform over the entire length.

### <(b) Contained Iron Carbide or Iron>

In the specification, the filling proportion (10 to 90%) of iron carbide or iron (b) in the internal space of a carbon tube selected from the group consisting of the nanoflake carbon tubes (a-1) and nested multi-walled carbon nanotubes (a-2) is determined by transmission electron microscopic observation of the iron-carbon composites (IV) usable in the invention, and is the proportion of the area of an image of the portion filled with iron carbide or iron (b) relative to the area of an image of the internal space of the carbon tube (that is, the space defined by the wall of the carbon tube).

The iron carbide or iron (b) can be contained in the tubes in various ways, such as the carbon tube internal spaces being continuously filled, or the carbon tube internal spaces being intermittently filled, but generally the spaces are intermittently filled. Therefore, the iron-carbon composites (IV) usable in the invention may also be called metal-containing carbon composites, iron-compound-containing carbon composites, or iron carbide- or iron-containing carbon composites.

The iron carbide or iron (b) contained in the iron-carbon composites (IV) usable in the invention is oriented in the lengthwise direction of the carbon tubes, and has high crystallinity, and the proportion of the area of a TEM image of crystalline iron carbide or iron (b) relative to the area of a TEM image of the region filled with iron carbide or iron (b) (hereinafter referred to as the "crystallinity ratio") is generally about 90 to 100%, and preferably about 95 to 100%.

The high crystallinity of the contained iron carbide or iron (b) is clear from the lattice pattern arrangement shown in the TEM image of the contained substance taken from the side of the iron-carbon composites (IV), and is also clear from the distinct diffraction pattern obtained in electron beam diffraction.

The presence of iron carbide or iron (b) as contained in the iron-carbon composites (IV) usable in the invention can be easily confirmed by electron microscopy and EDX (energy dispersive X-ray analyzer).

### <Overall Shape of Iron-Carbon Composites>

The iron-carbon composites (IV) usable in the invention have slight curvature, a straight shape, and a wall thickness substantially uniform over the entire length, and therefore have a uniform shape over the entire length. The shape is columnar, and mainly cylindrical.

The iron-carbon composites (IV) preferably have a mean outside diameter of about 1 to 100 nm, a mean length of about 0.1 to 1,000 µm, and a mean aspect ratio of about 1 to 1,000,000; more preferably have a mean outside diameter of about 1 to 100 nm, a mean length of about 0.1 to 1,000 µm, and a mean aspect ratio of about 5 to 10,000; and still more preferably have a mean outside diameter of about 1 to 50 nm, a mean length of about 1 to 400 µm, and a mean aspect ratio of about 10 to 10,000.

The term "straight shape" used to describe the shape of the iron-carbon composites (IV) usable in the invention is defined as a shape characteristic such that the ratio W/Wₒ is at least 0.8, and particularly at least 0.9, wherein W is the length of the image of a carbonaceous material comprising the iron-carbon composites (IV) usable in the invention observed over an area of 200 to 2000 nm square with a transmission electron microscope, and Wₒ is the length when said image has been extended linearly.

The iron-carbon composites (IV) usable in the invention have the following properties when considered as a bulk material. Specifically, in the invention, the iron-carbon composites (IV), in each of which iron or iron carbide (b) fills 10 to 90% of the internal space of a carbon tube selected from the group consisting of the nanoflake carbon tubes (a-1) and nested multi-walled carbon nanotubes (a-2), are a bulk material comprising numerous iron-carbon composites (IV) and are obtained in a large quantity in the form of a material that should also be called a carbonaceous material comprising iron-carbon composites (IV), or an iron carbide- or iron-containing carbonaceous material, as opposed to a minute amount, which can be barely observed by microscopic observation.

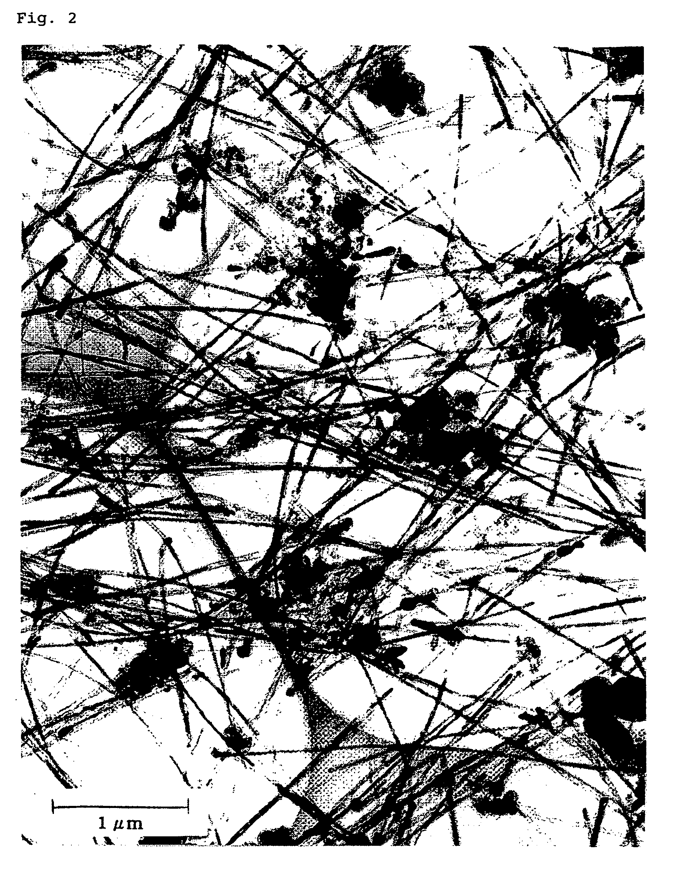

Fig. 2 is an electron micrograph of the carbonaceous material usable in the invention, which is obtained in Example 1 of Japanese Unexamined Patent Publication No. 2002-338220, the material comprising nanoflake carbon tubes (a-1) and iron carbide (b) contained in the internal spaces of the tubes.

As seen from Fig. 2, in the carbonaceous material comprising the iron-carbon composites (IV) usable in the invention, iron or iron carbide (b) fills 10 to 90% of the internal space (that is, the space surrounded by the walls of the carbon tubes) of basically almost all (particularly 99% or more) of the carbon tubes, usually there are substantially no carbon tubes whose internal space is empty. In some cases, however, a minute amount of carbon tubes not containing iron carbide or iron (b) may be contained.

Also, with the carbonaceous material for use in the invention, the iron-carbon composites (IV) in which iron or iron carbide (b) fills 10 to 90% of the internal spaces of the carbon tubes are the main component, but there may be cases in which soot or other materials are included besides to the iron-carbon composites (IV) usable in the invention. In such cases, any components other than the iron-carbon composites can be removed so as to increase the purity of the iron-carbon composites (IV) in the carbonaceous material usable in the invention, and to thereby obtain a carbonaceous material consisting essentially of the iron-carbon composites (IV).

Also, unlike prior art materials that could only be observed in minute amounts by microscopic observation, the carbonaceous material containing iron-carbon composites (IV) for use in the present invention can be synthesized in large quantities, and a weight of 1 mg or more can be easily achieved.

In the powder X-ray diffraction measurement of the carbonaceous material usable in the invention, in which the carbonaceous material is irradiated with a CuKα X-ray over an irradiation area of at least 25 mm² per mg of the carbonaceous material, the ratio R (= Ia/Ib) is preferably about 0.35 to 5, particularly about 0.5 to 4, and more preferably about 1 to 3, wherein Ia is the integrated intensity of the peak having the strongest integrated intensity among the peaks appearing in the range of 40 degrees < 2θ < 50 degrees assigned to iron or iron carbide (b) contained in the carbon tubes, and Ib is the integrated intensity of the peak appearing in the range of 26 degrees < 2θ < 27 degrees assigned to the mean spacing between the hexagonal carbon layers (d₀₀₂) of the carbon tubes.

The ratio of Ia/Ib is herein called the R value. Since the peak intensity is viewed as an average value among the carbonaceous material as a whole when the carbonaceous material comprising iron-carbon composites (IV) usable in the invention is observed by X-ray diffraction over an X-ray irradiation area of at least 25 mm², the R value does not represent the content or filling proportion of iron carbide or iron (b) in the single iron-carbon composite (IV) that can be measured by TEM analysis, but represents an average value of the iron carbide or iron (b) content or filling proportion for the carbonaceous material as a whole, which comprises a group of iron-carbon composites (IV).

Furthermore, the average filling proportion for the entire carbonaceous material containing a large number of the iron-carbon composites (IV) usable in the invention can also be determined by observing various fields by TEM, measuring the average iron carbide- or iron (b)-filling proportion in various iron-carbon composites (IV) observed in each field, and calculating the average value of the average filling proportions in said various fields. With this measurement process, the average iron carbide- or iron (b)-filling proportion for the entire carbonaceous material comprising the iron-carbon composites (IV) for use in the invention is about 10 to 90%, and preferably about 40 to 70%.

### <Nanoflake Carbon Tubes>

By acid treatment of the iron-carbon composites (IV) in which iron or iron carbide (b) partially fills the internal spaces of nanoflake carbon tubes (a-1), the iron or iron carbide (b) contained therein is dissolved, whereby hollow nanoflake carbon tubes (III), which do not contain iron or iron carbide (b) in their internal spaces, can be obtained.

Acids usable for the acid treatment include hydrochloric acid, sulfuric acid, nitric acid, and hydrofluoric acid. The concentration of such an acid is preferably about 0.1 to about 2N. The acid treatment can be carried out in various ways. For example, 1 g of iron-containing nanoflake carbon tubes is dispersed in 100 ml of 1N hydrochloric acid, and the dispersion is stirred at room temperature for 6 hours and filtered, followed by two cycles of the same steps using 100 ml of 1N hydrochloric acid, to thereby obtain hollow nanoflake carbon tubes (III).

Such an acid treatment does not substantially change the basic structure of the nanoflake carbon tubes (III). Therefore, in the hollow nanoflake carbon tubes (III) containing no iron or iron carbide (b) in the internal spaces thereof, the outermost hexagonal carbon layer has a length of not more than 500 nm, preferably 2 to 500 nm, and more preferably 10 to 100 nm.

### 1-2. Covering Layer

The covering layer comprises titanium oxide particles (1b) connected to one another.

There are no limitations on the crystal structure of the titanium oxide particles (1b). The titanium oxide particles (1b) preferably comprise at least one member selected from the group consisting of anatase titanium oxide, rutile titanium oxide, and brookite titanium oxide. The titanium oxide particles (1b) comprising anatase titanium oxide are more preferable because of their high photoactivity. The crystal structure of the titanium oxide particles (1b) can be measured by, e.g., X-ray diffraction or Raman spectroscopic analysis.

The mean particle size of the titanium oxide particles (1b) is preferably 1 to 200 nm, and more preferably 1 to 50 nm, in order to adsorb a greater amount of dye, and absorb a greater amount of light. However, the titanium oxide particles (1b) may also incorporate titanium oxide particles having greater light scattering, in order to achieve a light-confinement effect inside a cell. The mean particle size can be measured by, e.g., electron microscopic (SEM or TEM) observation.

The thickness of the covering layer is preferably 2 to 500 nm, and more preferably 5 to 200 nm, in order to prevent the occurrence of leakage current. The thickness of the covering layer can be measured by, e.g., electron microscopic (SEM or TEM) observation.

### 1-3. Titanium Oxide-Covered Carbon Material (1)

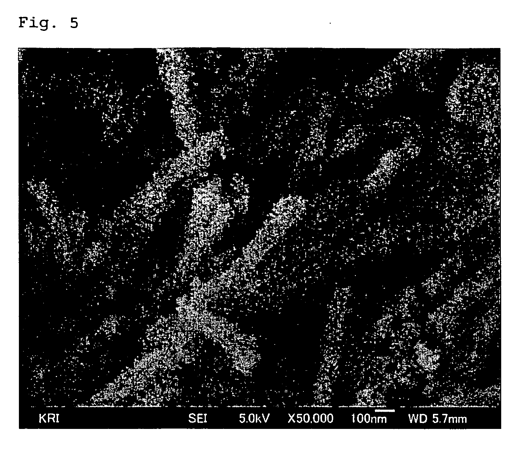

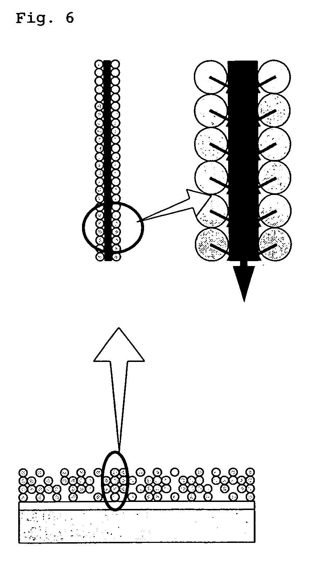

The titanium oxide-covered carbon material (1) of the invention comprises rod-like or fibrous carbon (1a), and titanium oxide particles (1b), wherein a surface of the carbon (1a) is covered with a covering layer comprising the titanium oxide particles (1b) connected to one another. Thus, as shown in Fig. 5, fine irregularities are present on the surface of the rod-like or fibrous titanium oxide-covered carbon material (1) of the invention. The use of the titanium oxide-covered carbon material (1) having fine irregularities on the surface for dye-sensitized solar cells allows a large amount of dye to be deposited on the surface, enabling efficient absorption of incident light. This enables efficient production of electrons, and, as shown in Fig. 6, the electrons can be efficiently transported to the transparent electrode via the carbon serving as the core material.

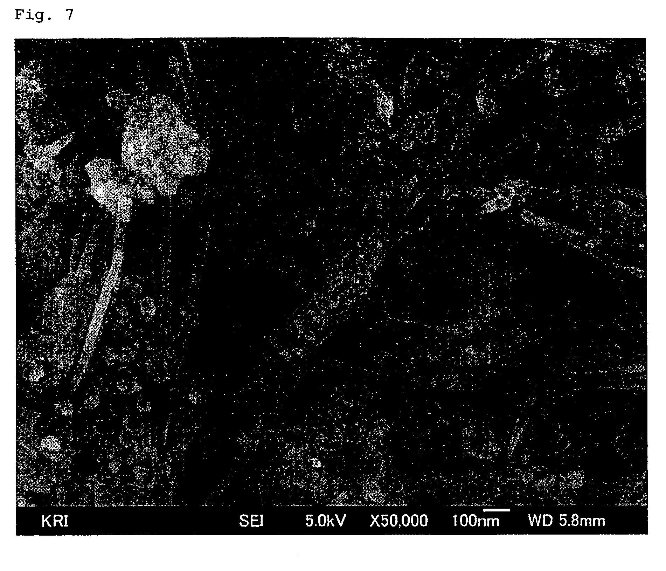

Note that if a titanium oxide-covered carbon material as shown in Fig. 7, which is not sufficiently covered with a covering layer and has a large area of exposed carbon, is used, the electrons produced by light absorption will undergo reverse electron transfer from the carbon into the electrolytic solution, precluding efficient electron transfer. From this viewpoint, regarding the rod-like or fibrous titanium oxide-covered carbon material (1) of the invention, 70 to 100%, and more preferably 85 to 100% of the surface of the rod-like or fibrous carbon (1a) is covered with the titanium oxide particles (1b). The element ratio (C/Ti) of carbon and titanium on the surface of the rod-like or fibrous titanium oxide-covered carbon material (1) is preferably 0/100 to 70/30 (atomic ratio), and more preferably 0/100 to 50/50 (atomic ratio). The proportion of the surface covering (i.e., the proportion of the area on the carbon surface covered with the covering layer comprising titanium oxide particles connected to one another) can be measured by, e.g., electron microscopic (SEM or TEM) observation. The element ratio (C/Ti) of carbon and titanium on the surface of the rod-like or fibrous titanium oxide-covered carbon material (1) can be measured by, e.g., X-ray photoelectron spectroscopic analysis.

The titanium oxide-covered carbon material (1) of the invention preferably has a powder resistance at 10 MPa of 10 Ω·m or less, more preferably 5 Ω·m or less, and still more preferably 1 Ω·m or less, in order to generate a larger amount of current.
It is preferable that the powder resistance be lower; although the lower limit thereof is not limited, it is about 0.0001 Ω·m. The powder resistance of the titanium oxide-covered carbon material (1) can be measured by, e.g., processing the titanium oxide-covered carbon material (1) into a 0.3 mm thick tabular shape at a pressure of 10 MPa, applying a voltage of 1 V across the pellets, and measuring the value of the current flow.

In order to provide the titanium oxide-covered carbon material (1) of the invention with a sufficient surface area and efficient transfer of electrons, the titanium oxide-covered carbon material (1) preferably has a mean diameter of 5 to 500 nm perpendicular to the long axis, a mean long-axis length of 0.1 to 1,000 µm, and a mean aspect ratio of 3 to 200,000; more preferably has a mean diameter of 5 to 500 nm perpendicular to the long axis, a mean long-axis length of 0.1 to about 1,000 µm, and a mean aspect ratio of 3 to 5,000; and still more preferably has a mean diameter of 7 to 300 nm perpendicular to the long axis, a mean long-axis length of 1 to 50 µm, and a mean aspect ratio of 10 to 3,000. In the invention, the diameter of the titanium oxide-covered carbon material (1) refers to the diameter including not only the diameter of the core material carbon, but also the thickness of the titanium oxide covering.

The titanium oxide-covered carbon material (1) of the invention preferably has a specific surface area of 50 m²/g or more, more preferably 70 m²/g or more, and still more preferably 80 m²/g or more, in order to provide a large surface area, allow a greater amount of dye to be deposited thereon, and efficiently absorb incident light. It is preferable that the specific surface area be larger; although the upper limit thereof is not limited, it is about 3,000 m²/g. The specific surface area can be measured by, e.g., the BET method.

### 1-4. Process for Producing Titanium Oxide-Covered Carbon Material (1)

The titanium oxide-covered carbon material (1) of the invention is obtained by forming a covering layer comprising titanium oxide particles (1b) by a process comprising:
Step (A) of forming a covering layer comprising titanium oxide particles (1b) connected to one another on a surface of rod-like or fibrous carbon (1a) by performing a precipitation reaction from a fluorotitanate complex.

In Step (A), a covering layer comprising titanium oxide particles (1b) connected to one another is formed on a surface of a rod-like or fibrous carbon (1a) by performing a precipitation reaction from a fluorotitanate complex, thereby preparing a titanium oxide-covered carbon material (1).

The covering layer comprising titanium oxide particles (1b) connected to one another can be formed on the surface of the rod-like or fibrous carbon (1a) according to a sol-gel process using a titanium alkoxide as the starting material, or a wet process using titanium tetrachloride as the starting material. However, it is preferable to employ the method wherein titanium oxide particles (1b) are precipitated from a fluorotitanate complex by the precipitation reaction.

The method specifically comprises, for example, treating the rod-like or fibrous carbon (1a) with an acid such as nitric acid, sulfuric acid, or hydrochloric acid; dispersing the treated nanoscale carbon in a solvent containing a dispersant; and adding thereto a fluorotitanate complex and a fluoride-ion scavenger, such as boric acid or aluminum chloride, to precipitate titanium oxide. The titanium oxide precipitate may subsequently be heat-treated at 300 to 550°C, in order to strengthen the bond between titanium oxide particles.

Examples of fluorotitanate complexes include, but are not limited to, ammonium hexafluorotitanate, hexafluorotitanic acid, and potassium hexafluorotitanate.

Examples of solvents include, but are not limited to, solvents that dissolve the fluorotitanate complex, such as water, and a solvent mixture of water and an alcohol.

Examples of dispersants include anionic dispersants such as sodium naphthalene sulfonate formalin condensate dispersants, polycarboxylic acid salt dispersants, maleic acid-α-olefin copolymer salt dispersants, and anionic surfactants; cationic dispersants such as quarternary ammonium salt dispersants and alkylamine salts; nonionic dispersants such as cellulose dispersants, polyvinyl alcohol dispersants, and polyether dispersants; and other dispersants such as ampholytic surfactants. Among the above, nonionic dispersants are preferable, and polyether dispersants are more preferable.

### 2. Porous Titanium Oxide-Covered Carbon Material Composition

The porous titanium oxide-covered carbon material composition of the invention is a mixture of:
(1) a rod-like or fibrous titanium oxide-covered carbon material comprising rod-like or fibrous carbon (1a), and a covering layer comprising titanium oxide particles (1b) connected to one another, wherein a surface of the rod-like or fibrous carbon (1a) is covered with the covering layer; and
(2) titanium oxide particles.

### 2-1. Titanium Oxide-Covered Carbon Material (1)

The titanium oxide-covered carbon material (1) of the invention is the same as that described in section 1. above, i.e., it comprises rod-like or fibrous carbon (1a) and a covering layer comprising titanium oxide particles (1b) connected to one another, wherein a surface of the carbon (1a) is covered with the covering layer.

### 2-2. Titanium Oxide Particles (2)

Titanium oxide particles that are the same or different from the titanium oxide particles (1b) used in the preparation of the titanium oxide-covered carbon material (1) may be used as the titanium oxide particles (2). Specific examples of usable titanium oxide particles are as follows.

There are no limitations on the crystal structure of the titanium oxide particles (2); however, the titanium oxide particles (2) preferably comprise at least one member selected from the group consisting of anatase titanium oxide, rutile titanium oxide, and brookite titanium oxide. The titanium oxide particles (2) comprising anatase titanium oxide are preferable because of their high photoactivity. The crystal structure of the titanium oxide particles (2) can be measured by, e.g., X-ray diffraction or Raman spectroscopic analysis.

The mean particle size of the titanium oxide particles (2) is preferably 1 to 500 nm, and more preferably 5 to 100 nm, in order to adsorb a greater amount of dye, and absorb a greater amount of light. However, the titanium oxide particles (2) may also incorporate titanium oxide particles having greater light scattering, in order to achieve a light-confinement effect inside a cell. The mean particle size can be measured by, e.g., electron microscopic (SEM or TEM) observation.

### 2-3. Porous Titanium Oxide-Covered Carbon Material Composition

The porous titanium oxide-covered carbon material composition of the invention is a mixture of the titanium oxide-covered carbon material (1) and titanium oxide particles (2) described above.

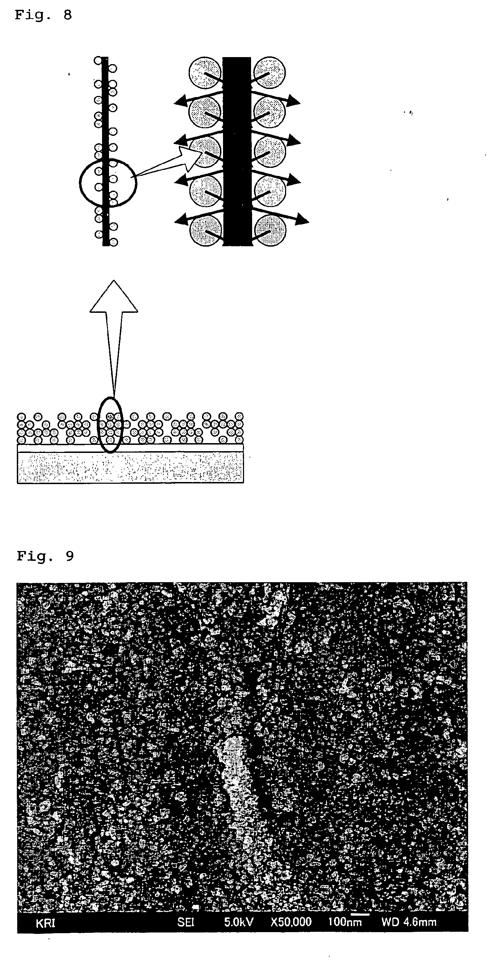

In the invention, the titanium oxide-covered carbon material (1) may be used alone or in admixture with the titanium oxide particles (2). When the porous titanium oxide-covered carbon material composition is obtained by mixing the titanium oxide-covered carbon material (1) with the titanium oxide particles (2), the number of fine irregularities on the surface of the composition can be increased, as shown in Fig. 9, allowing a dye to be easily deposited on the surface.

In order to reduce leakage current through the carbon material while utilizing the conductivity of the carbon material, the porous titanium oxide-covered carbon material composition of the invention preferably comprises the titanium oxide-covered carbon material (1) in a proportion of 0.1 to 90 wt%, more preferably 0.1 to 80 wt%, still more preferably 0.1 to 60 wt%, even more preferably 0.2 to 40 wt%, and still even more preferably 0.25 to 20 wt%; and the titanium oxide particles (2) in a proportion of 10 to 99.9 wt%, more preferably 20 to 99.9 wt%, still more preferably 40 to 99.9 wt%, even more preferably 60 to 99.8 wt%, and still even more preferably 80 to 99.75 wt%. The use of the titanium oxide-covered carbon material (1) in a proportion of 60 wt% or less also results in great ease of application of the composition and a high covering-film strength. This provides the advantage of achieving substantially uniform, stable conductivity and photoelectric conversion efficiency. This also provides the advantage of achieving higher photoelectric conversion efficiency at lower costs.

The porous titanium oxide-covered carbon material composition of the invention preferably comprises 40 to 100%, and more preferably 60 to 100%, of pores having a pore size of 5 to 50 nm of the total volume of pores, in order to provide a large surface area per unit volume, and maintain the ion-diffusion properties of the electrolytic solution.

The porous titanium oxide-covered carbon material composition of the invention preferably has a specific surface area of 50 m²/g or more, more preferably 70 m²/g or more, and still more preferably 80 m²/g or more, in order to provide a large surface area, allow a greater amount of dye to be deposited thereon, and efficiently absorb incident light. It is preferable that the specific surface area be larger; although the upper limit thereof is not limited, it is about 3,000 m²/g. The specific surface area can be measured by, e.g., the BET method. However, in order to achieve a light-confinement effect inside a cell, the titanium oxide-covered carbon material (1) may also incorporate, on its surface, titanium oxide having greater light-scattering, i.e., having a greater particle size and a smaller specific surface area. Thus, the titanium oxide particles (2) may comprise titanium oxide particles having a greater particle size and a smaller specific surface area.

### 2-4. Process for Producing Porous Titanium Oxide-Covered Carbon Material Composition

The porous titanium oxide-covered carbon material composition of the invention is obtained by a process comprising:
(A) forming a covering layer comprising titanium oxide particles (1b) connected to one another on a surface of rod-like or fibrous carbon (1a) by performing a precipitation reaction from a fluorotitanate complex, thereby preparing a titanium oxide-covered carbon material (1); and
(B) mixing the titanium oxide-covered carbon material (1) obtained in Step (A) with titanium oxide particles (2).

### Step (A)

Step (A) is the same as described in item (1-4) above.

### Step (B)

In Step (B), the titanium oxide-covered carbon material (1) obtained in Step (A) is mixed with titanium oxide particles (2).

Examples of mixing methods include, but are not limited to, known mixing methods using a paint shaker and a mortar, as well as various known mixing methods using, e.g., a ball mill, a sand mill, a jet mill, a kneader, and a roller. The titanium oxide-covered carbon material (1) and titanium oxide particles (2) may be diluted with a low-viscosity solvent, and then mixed using, e.g., a paint shaker, after which the solvent is removed by distillation under reduced pressure.

### 3. Photoelectric Conversion Element

The photoelectric conversion element of the invention includes, for example, a conductive substrate, a semiconductor layer, a charge transport layer, and an opposite electrode.

The conductive substrate typically has an electrode layer on the substrate. The material, thickness, dimensions, shape, and the like of the substrate can be suitably selected according to the purpose. Examples of usable substrates include, but are not limited to, metals, colorless or colored glass, wired sheet glass, glass blocks, and colorless or colored resins. Examples of such resins include polyesters, such as polyethylene terephthalate, polyamides, polysulfones, polyethersulfones, polyether ether ketones, polyphenylene sulfides, polycarbonates, polyimides, polymethyl methacrylates, polystyrenes, cellulose triacetate, and polymethylpentene. The substrate used in the invention has smooth surfaces at room temperature. The surfaces may be flat or curved, or may deform under stress.

Examples of materials of the conductive film that functions as an electrode include, but are not limited to, metals such as gold, silver, chromium, copper, tungsten, and titanium; metal thin films; and metal oxides. Examples of metal oxides that can be suitably used include metal oxides of tin, zinc, and the like that are doped with trace amounts of other metal elements, such as indium tin oxide (ITO; In₂O₃:Sn), fluorine-doped tin oxide (FTO; SnO₂:F), aluminum-doped zinc oxide (AZO; ZnO:Al), and antimony-doped tin oxide (ATO; SnO₂:Sb).

The film thickness of the conductive film is typically 100 to 10,000 nm, and preferably 500 to 3,000 nm. The surface resistance (resistivity) of the conductive film may be suitably selected, but is typically 0.5 to 500 Ω/sq, and preferably 1 to 50 Ω/sq.

There are no limitations on the method for forming a conductive film; any known method can be suitably employed according to the type of metal or metal oxide used. Typically, methods such as vacuum deposition, ion-plating, CVD, and sputtering can be used. In any case, a conductive film is preferably formed at a substrate temperature of 20 to 700°C.

The opposite electrode (counter electrode) for use in the photoelectric conversion element of the invention may have a monolayer structure made of a conductive material, or may include a conductive layer and a substrate. The material, thickness, dimensions, shape, and the like of the substrate can be suitably selected according to the purpose. Examples of usable conductive substrates include, but are not limited to, metals, colorless or colored glass, wired sheet glass, glass blocks, and resins. Examples of such resins include polyesters, such as polyethylene terephthalate, polyamides, polysulfones, polyethersulfones, polyether ether ketones, polyphenylene sulfides, polycarbonates, polyimides, polymethyl methacrylates, polystyrenes, cellulose triacetate, and polymethylpentene. Alternatively, a conductive material may be directly applied, plated, or deposited (by PVD or CVD) on the charge transport layer, and an opposite electrode may be formed thereon.

Conductive materials used herein include materials with low specific resistance, e.g., metals such as platinum, gold, nickel, titanium, aluminum, copper, silver, and tungsten, carbon materials, and conductive organic materials.

A metal lead may also be used to reduce the resistance of the counter electrode. The metal lead is preferably made of platinum, gold, nickel, titanium, aluminum, copper, silver, tungsten, or the like, and particularly preferably made of aluminum or silver.

A semiconductor layer made of the above-described titanium oxide-covered carbon material (1) or porous titanium oxide-covered carbon material composition of the invention is used as the semiconductor layer. There are no limitations on the orientation of the titanium oxide-covered carbon material of the invention; the titanium oxide-covered carbon material need not be oriented in a particular direction, e.g., it need not be oriented such that the lengthwise direction thereof is substantially perpendicular to the substrate.

A semiconductor layer may be formed on the conductive substrate by, e.g., a method wherein a paste containing the titanium oxide-covered carbon material or porous titanium oxide-covered carbon material composition of the invention is prepared, and the paste is applied to the conductive substrate and fired. Solvents usable for the paste include water and organic solvents.

Any organic solvents can be used, as long as they can disperse the titanium oxide-covered carbon material or porous titanium oxide-covered carbon material composition of the invention. Examples of usable organic solvents include alcohols such as ethanol, methanol, and terpineol; and glycols such as ethylene glycol, polyethylene glycol, propylene glycol, and polypropylene glycol. These solvents are typically used in combination, in consideration of their dispersibilities, volatilities, and viscosities. The proportion of the solvents in the paste is preferably 50 to 90 wt%, and more preferably 70 to 85 wt%, in order to provide fluidity during application, maintain the thickness upon application, and form porous titanium oxide.

In addition to the above-mentioned solvents, the dispersion may further contain a thickener and other components.

Examples of thickeners include alkyl celluloses, such as methylcellulose and ethylcellulose. Among these, an alkyl cellulose, and particularly ethylcellulose, can be suitably used.

The proportion of the thickener in the paste is preferably 2 to 20 wt%, and more preferably 3 to 15 wt%, in order to provide a good balance between fluidity during application and thickness upon application.

The proportion of solids in the paste is preferably 10 to 50 wt%, and more preferably 15 to 30 wt%, in order to provide a good balance between fluidity during application and thickness upon application, as noted above. Further, the proportion of the titanium oxide-covered carbon material (1) in the solids is preferably 0.1 to 90 wt%, more preferably 0.1 to 80 wt%, still more preferably 0.1 to 60 wt%, even more preferably 0.2 to 40 wt%, and still more preferably 0.25 to 20 wt%.

The photoelectric conversion element of the invention comprises a dye deposited (e.g., adsorbed or contained) on the semiconductor layer, in order to, for example, improve the light absorption efficiency of the semiconductor layer.

There are no limitations on dyes as long as they have absorption properties in the visible and near-infrared regions, and can improve (sensitize) the light absorption efficiency of the semiconductor layer. Preferable dyes include metal complex dyes, organic dyes, natural dyes, and semiconductors. Further, dyes having, in their molecules, functional groups, such as carboxy, hydroxy, sulfonyl, phosphonyl, carboxyalkyl, hydroxyalkyl, sulfonylalkyl, and phosphonylalkyl groups, are suitably used, in order to provide adsorbability to the semiconductor layer.

Examples of usable metal complex dyes include ruthenium, osmium, iron, cobalt, zinc, and mercury complexes; metal phthalocyanines; and chlorophylls. Examples of organic dyes include, but are not limited to, cyanine dyes, hemicyanine dyes, merocyanine dyes, xanthene dyes, triphenylmethane dyes, and metal-free phthalocyanine dyes. Preferable semiconductors that can be used as dyes are i-type amorphous semiconductors having high optical absorption coefficients, direct band-gap semiconductors, and semiconductor particles that exhibit quantum size effects and efficiently absorb visible light. Typically, these various semiconductors, metal complex dyes, and organic dyes can be used singly, or can be used in a combination of two types or more, to broaden the wavelength region of photoelectric conversion as much as possible, and to increase the conversion efficiency. The dyes to be mixed and their proportions can be selected to match the desired wavelength region and intensity distribution of the light source.

A dye can be adsorbed on the semiconductor layer by, e.g., a method wherein a solution obtained by dissolving the dye in a solvent is applied to the semiconductor layer by, e.g., spray coating or spin coating, and the solution is subsequently dried. In this case, the substrate may be heated to an appropriate temperature. A method wherein the dye is adsorbed by immersing the semiconductor layer in the solution can also be used. The immersion time is not limited as long as the dye is sufficiently adsorbed, but it is preferably 10 min to 30 hr, and more preferably 1 to 20 hr. If necessary, the solvent and the substrate may be heated during the immersion. The concentration of the dye when prepared into a solution is 1 to 1,000 mmol/L, and preferably about 10 to 500 mmol/L.

There are no limitations on the solvent used, but water and organic solvents are preferably used. Examples of organic solvents include alcohols such as methanol, ethanol, 1-propanol, 2-propanol, 1-butanol, 2-butanol, and t-butanol; nitriles such as acetonitrile, propionitrile, methoxypropionitrile, and glutaronitrile; aromatic hydrocarbons such as benzene, toluene, o-xylene, m-xylene, and p-xylene; aliphatic hydrocarbons such as pentane, hexane, and heptane; alicyclic hydrocarbons such as cyclohexane; ketones such as acetone, methyl ethyl ketone, diethyl ketone, and 2-butanone; ethers such as diethylether and tetrahydrofuran; ethylene carbonate; propylene carbonate; nitromethane; dimethyl formamide; dimethyl sulfoxide; hexamethylphosphoramide; dimethoxyethane; γ-butyrolactone; γ-valerolactone; sulfolane; dimethoxyethane; adiponitrile; methoxyacetonitrile; dimethylacetamide; methylpyrrolidinone; dimethylsulfoxide; dioxolane; sulfolane; trimethyl phosphate; triethyl phosphate; tripropyl phosphate; ethyl dimethyl phosphate; tributyl phosphate; tripentyl phosphate, trihexyl phosphate, triheptyl phosphate, trioctyl phosphate, trinonyl phosphate, tridecyl phosphate, tris(trifluoromethyl)phosphate; tris(pentafluoroethyl)phosphate; triphenyl polyethylene glycol phosphate; and polyethylene glycol.

In order to reduce aggregation or like interactions between dye particles, a colorless compound having surfactant properties may be added to the solution containing the adsorbed dye, and the compound may be co-adsorbed on the semiconductor layer. Examples of such colorless compounds include sulfonates and steroid compounds having carboxy or sulfo groups, such as cholic acid, deoxycholic acid, chenodexycholic acid, and taurodeoxycholic acid.

After the adsorption step, unadsorbed dye is preferably rapidly removed by washing. Washing is preferably performed in a wet washing tank using acetonitrile, an alcohol solvent, or the like.

After the adsorption of the dye, the surface of the semiconductor layer may be treated with, e.g., an amine, a quarternary ammonium salt, an ureido compound having at least one ureido group, a silyl compound having at least one silyl group, an alkali metal salt, or an alkaline earth metal salt. Examples of preferable amines include pyridine, 4-t-butylpyridine, and polyvinyl pyridine. Examples of preferable quarternary ammonium salts include tetrabutylammonium iodide and tetrahexylammonium iodide. These compounds may be dissolved in organic solvents, or may be used as is if they are liquids.

The charge transport layer contains a charge transport material that functions to supplement the oxidized dye with electrons. The charge transport material used herein is a charge transport material utilizing ions. Examples of such charge transport materials include solutions in which redox-pair ions are dissolved; gel electrolyte compositions in which polymer-matrix gels are impregnated with the solutions of redox pairs; and solid electrolyte compositions.

The electrolytic solution used as a charge transport material utilizing ions preferably includes an electrolyte, a solvent, and additives. Examples of electrolytes used in the electrolytic solution include combinations of iodine and iodides (metal iodides, such as LiI, NaI, KI, CsI, and CaI₂; and salts of quaternary ammonium compounds and iodine, such as tetraalkyl ammonium iodide, pyridinium iodide, and imidazolium iodide); combinations of bromine and bromides (metal bromides, such as LiBr, NaBr, KBr, CsBr, CaBr, and CaBr₂; and salts of quaternary ammonium compounds and bromine, such as tetraalkylammonium bromide and pyridinium bromide); metal complexes such as ferrocyanate-ferricyanate and ferrocene-ferricinium ions; sulfur compounds such as polysodium sulfide and alkylthiol-alkyl disulfide; viologen dyes; and hydroquinone-quinone. Preferable among these are electrolytes made of combinations of I₂ and LiI or salts of quaternary ammonium compounds and iodine, such as pyridinium iodide and imidazolium iodide. These electrolytes may also be used in combination.

Any solvents that are generally used in electrochemical cells and batteries can be used as the solvent. Specific examples of usable solvents include acetic anhydride, methanol, ethanol, tetrahydrofuran, propylene carbonate, nitromethane, acetonitrile, dimethylformamide, dimethyl sulfoxide, hexamethylphosphoramide, ethylene carbonate, dimethoxyethane, γ-butyrolactone, γ-valerolactone, sulfolane, dimethoxyethane, propionitrile, glutaronitrile, adiponitrile, methoxyacetonitrile, dimethylacetamide, methylpyrrolidinone, dimethyl sulfoxide, dioxolane, sulfolane, trimethyl phosphate, triethyl phosphate, tripropyl phosphate, ethyl dimethyl phosphate, tributyl phosphate, tripentyl phosphate, trihexyl phosphate, triheptyl phosphate, trioctyl phosphate, trinonyl phosphate, tridecyl phosphate, tris(trifluoromethyl)phosphate, tris(pentafluoroethyl)phosphate, triphenyl polyethylene glycol phosphate, and polyethylene glycol. Particularly preferable are propylene carbonate, ethylene carbonate, dimethyl sulfoxide, dimethoxyethane, acetonitrile, γ-butyrolactone, sulfolane, dioxolane, dimethylformamide, dimethoxyethane, tetrahydrofuran, adiponitrile, methoxyacetonitrile, methoxypropionitrile, dimethylacetamide, methylpyrrolidinone, dimethyl sulfoxide, dioxolane, sulfolane, trimethyl phosphate, triethyl phosphate, and the like. Roomtemperature molten salts are also usable. The term "roomtemperature molten salts" herein means salts made of ion pairs that are molten (namely, liquid) at room temperature; these salts generally have melting points of 20°C or less, and are liquid at temperatures over 20°C. The above-mentioned solvents may be used alone or in a combination of two types or more.

Moreover, a basic compound such as 4-t-butylpyridine, 2-picoline, or 2,6-lutidine is preferably added to the molten salt electrolyte composition or electrolytic solution mentioned above. The concentration of a basic compound when it is added to the electrolytic solution is preferably in the range of 0.05 to 2 mol/L. When a basic compound is added to the molten salt electrolyte composition, the basic compound preferably has an ionic group. The proportion of the basic compound in the entire molten salt electrolyte composition is preferably 1 to 40 mass%, and more preferably 5 to 30 mass%.

There are no limitations on materials usable as polymer matrices, as long as they can form solids or gels alone, or when plasticizers, support electrolytes, or plasticizers and support electrolytes are added thereto. Polymer compounds generally used as polymer matrices can be used.

Examples of such polymer compounds having properties as polymer matrices include polymer compounds obtained by polymerization or copolymerization of monomers, such as hexafluoropropylene, tetrafluoroethylene, trifluoroethylene, ethylene, propylene, acrylonitrile, vinylidene chloride, acrylic acid, methacrylic acid, maleic acid, maleic anhydride, methyl acrylate, ethyl acrylate, methyl methacrylate, styrene, and vinylidene fluoride. These polymer compounds may be used alone or as mixtures. Among the above, a polyvinylidene fluoride-based polymer compound is preferable.

The charge transport layer can be formed according to either of the following two methods: A first method includes inserting a liquid charge transport layer into a gap formed between a semiconductor layer and a counter electrode that have previously been laminated. A second method includes forming a charge transport layer directly on a semiconductor layer, followed by the formation of a counter electrode.

In the former method, the charge transport layer can be inserted using an atmospheric pressure process that utilizes capillary action during, e.g., immersion, or using a vacuum process wherein the gaseous phase in the gap is replaced with the liquid phase by setting the pressure lower than the atmospheric pressure.

When a wet charge transport layer is used in the latter method, a counter electrode is typically formed in an undried state, and a means for preventing liquid leakage is provided for the edge portions. Furthermore, when a gel electrolyte composition is used, it may be applied wet and subsequently, solidified by polymerization or a like method. The solidification may be performed prior to or subsequent to the formation of a counter electrode.

### [Examples]

The present invention will be described in detail with reference to examples; however, the invention is not limited to these examples.

### Comparative Example 1

Titanium oxide particles with a particle size of 20 nm were processed into a 0.3 mm-thick tabular shape at a pressure of 10 MPa, and a voltage of 1 V was applied across the pellets. The value of the current flow was 0.01 mA. This shows that the powder resistance was 26,500 Ω·m.

### Example 1

150 g of 69% nitric acid was added to 0.96 g of nanoscale carbon tubes (mean diameter: 35 nm, mean length: 5,000 nm, mean aspect ratio: 143), and the mixture was maintained for 6 hours at 90 to 95°C. The resulting material was filtered, washed with distilled water until the filtrate showed a pH of 6 to 7, and dried.

The dried product was dispersed in 100 g of distilled water containing 3.7 g of a polyether dispersant, using an ultrasonic homogenizer. To the nanoscale carbon dispersion was added ammonium hexafluorotitanate diluted to 1.0 M and boric acid diluted to 1.0 M in concentrations of 0.20 M and 0.4 M, respectively. The mixture was allowed to stand for 16 hours at 35°C, and subsequently filtered and dried to give a structure wherein the surface of the nanoscale carbon tubes was covered with titanium oxide (nanoscale carbon tubes covered with titanium oxide).

According to TG/DTA measurements, the nanoscale carbon tubes burned intensely near 550°C, whereas the prepared structure wherein the surface of the nanoscale carbon tubes was covered with titanium oxide burned mildly from 550 to 700°C. The mild combustion of the prepared structure is believed to be because the titanium oxide covered on the nanoscale carbon tubes suppressed the combustion.

The prepared structure and a structure obtained by firing the prepared structure for 1 hr at 500°C were subjected to X-ray diffractometry and Raman spectroscopic analysis to identify their crystal phases. Both of these structures were found to be in the anatase form. Graphite peaks derived from the nanoscale carbon tubes were also observed.

On the other hand, X-ray photoelectron spectroscopic analysis of the prepared structure showed that the carbon/titanium atomic ratio was 0.1, with only a slight amount of carbon detected. Further, electron microscopic (SEM) observation showed that the proportion of the titanium surface covering was about 98%. The proportion of the surface covering was measured, assuming that any smooth portion free of irregularities with a size of 1 nm or more (a portion of the carbon tubes not covered with titanium oxide) continuously present in a length of 5 nm or more was an uncovered portion where carbon tubes were exposed.

As opposed to X-ray diffractometry and Raman spectroscopic analysis, which reflect information of depths up to several micrometers, X-ray photoelectron spectroscopic analysis provides an analysis of a surface portion of several nanometers. Therefore, it was observed that the nanoscale carbon tubes were covered with the titanium oxide, without being exposed.

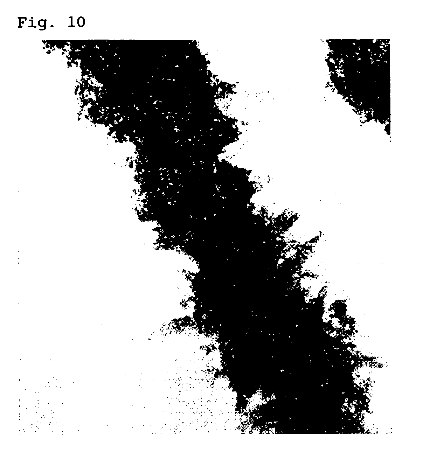

SEM and TEM observations of the structure produced the results shown in Figs. 5 and 10. The results showed that 5-20 nm titanium oxide particles were grouped into a fibrous form with a covering thickness of about 30 to about 50 nm, a mean diameter of 80 to 150 nm, a mean length of about 1,000 to about 10,000 nm, and a mean aspect ratio of about 10 to about 100.

Measurement of the specific surface area by the BET method showed that the titanium oxide particles had a specific surface area as large as 73 m²/g.

### Experimental Example 1-1

The structure prior to firing, which was prepared in Example 1, was processed into a 0.3 mm-thick tabular shape at a pressure of 10 MPa, and a voltage of 1 V was applied across the pellets. The results confirmed that the value of the current flow was 73 mA, and the powder resistance was 3.12 Ω·m, confirming that the structure of Example 1 exhibited a conductivity higher than that of the structure of Comparative Example 1 using titanium oxide particles, which was evaluated by the same method.

### Experimental Example 1-2

The structure prepared in Example 1 was heat-treated at 350°C and subsequently processed into a 0.3 mm-thick tabular shape at a pressure of 10 MPa; and a voltage of 1 V was applied across the pellets. The results confirmed that the value of the current flow was 608 mA, and the powder resistance was 0.43 Ω·m, confirming that the structure of Example 1 exhibited a conductivity higher than that of the structure of Comparative Example 1 using titanium oxide particles, which was evaluated by the same method.

### Example 2

150 g of 69% nitric acid was added to 0.48 g of nanoscale carbon tubes (mean diameter: 10 nm, mean length: 10 µm, mean aspect ratio: 1,000), and the mixture was maintained for 3 hours at 90 to 95°C. The resulting material was filtered, washed with distilled water until the filtrate showed a pH of 6 to 7, and dried.

The dried product was dispersed in 100 g of distilled water containing 3.7 g of a polyether dispersant, using an ultrasonic homogenizer. To the nanoscale carbon dispersion was added ammonium hexafluorotitanate diluted to 1.0 M and boric acid diluted to 1.0 M in concentrations of 0.1 M and 0.2 M, respectively. The mixture was allowed to stand for 20 hours at 35°C, and subsequently filtered and dried to give a structure wherein the surface of the nanoscale carbon tubes was covered with titanium oxide (nanoscale carbon tubes covered with titanium oxide).

Further, electron microscopic (SEM) observation showed that the proportion of the titanium surface covering was about 89%.

The nanoscale carbon tubes covered with titanium oxide were fired for 0.5 hr at 400°C, thereby giving the titanium oxide structure of Example 2.

The fired structure was subjected to X-ray diffractometry and Raman spectroscopic analysis to identify its crystal phase. The titanium oxide in the structure was found to be mainly in the anatase form.

Further, electron microscopic (SEM and TEM) observations showed that, on the surface of the nanoscale carbon tubes, 2-10 nm titanium oxide particles were grouped into a fibrous form with a thickness of about 10 to about 30 nm, a mean diameter of 30 to 70 nm, a mean length of about 5,000 to about 10,000 nm, and a mean aspect ratio of about 70 to about 300.

Measurement of the specific surface area by the BET method showed that the titanium oxide structure had a specific surface area as large as 160 m²/g.

### Experimental Example 2

The structure prepared in Example 2 (the nanoscale carbon tubes covered with titanium oxide) was heat-treated at 350°C and subsequently processed into a 0.3 mm-thick tabular shape at a pressure of 10 MPa; and a voltage of 1 V was applied across the pellets. The results confirmed that the value of the current flow was 746 mA, and the average powder resistance was 0.35 Ω·m.

### Example 3

150 g of 69% nitric acid was added to 0.96 g of nanoscale carbon tubes (mean diameter: 100 nm, mean length: 10 µm, mean aspect ratio: 100), and the mixture was maintained for 6 hours at 90 to 95°C. The resulting material was filtered, washed with distilled water until the filtrate showed a pH of 6 to 7, and dried.

The dried product was dispersed in 100 g of distilled water containing 3.7 g of a polyether dispersant, using an ultrasonic homogenizer. To the nanoscale carbon dispersion was added ammonium hexafluorotitanate diluted to 1.0 M and boric acid diluted to 1.0 M in concentrations of 0.2 M and 0.4 M, respectively. The mixture was allowed to stand for 24 hours at 35°C, and subsequently filtered and dried to give a structure wherein the surface of the nanoscale carbon tubes was covered with titanium oxide (nanoscale carbon tubes covered with titanium oxide).

Electron microscopic (SEM) observation showed that the titanium oxide surface covering was substantially free of defects.

The nanoscale carbon tubes covered with titanium oxide were fired for 1 hour at 500°C, thereby giving a structure of Example 3 wherein the surface of the nanoscale carbon tubes was covered with titanium oxide.

Further, electron microscopic (SEM and TEM) observations showed that 5-20 nm titanium oxide particles were grouped into a fibrous form with a thickness of about 30 to about 80 nm, a mean diameter of 160 to 260 nm, a mean length of about 1,000 to about 5,000 nm, and a mean aspect ratio of about 4 to about 30.

Measurement of the specific surface area by the BET method showed that the structure had a specific surface area of 80 m²/g.

### Experimental Example 3

The structure prepared in Example 3 (the nanoscale carbon tubes covered with titanium oxide) was heat-treated at 350°C and subsequently processed into a 0.3 mm-thick tabular shape at a pressure of 10 MPa; and a voltage of 1 V was applied across the pellets. The results confirmed that the value of the current flow was 843 mA, and the average powder resistance was 0.31 Ω·m.

### Examples 4 to 10 and Comparative Example 1

The titanium oxide-covered carbon material produced according to Example 1 was mixed with titanium oxide particles (crystal structure: anatase) having a mean particle size of 18 nm (manufactured by Catalyst & Chemicals Ind. Co. Ltd.; HPW-18NR) at the weight ratios shown in Table 1 (Comparative Example 1 uses only titanium oxide particles, and Example 10 uses only the titanium oxide-covered carbon material). 10 parts by weight of ethyl cellulose and 70 parts by weight of α-terpineol were added to 20 parts by weight of each of the resulting mixtures, and the mixture was kneaded with a three-roll mill to prepare a paste.

This paste was applied to a glass substrate with a transparent electrode using a screen printer, and fired for 1 hour at 500°C, thereby preparing an electrode film with a film thickness of 12 µm.

The electrode film was immersed for 18 hours at room temperature in a dehydrated ethanol solution of 5x10⁴ mol/L of a ruthenium complex (RuL₂(NCS)₂) dye (N3 Dye), and then dried to prepare an oxide porous electrode.

Next, a counter electrode made of a platinum-plated glass substrate with a transparent electrode was laminated to the oxide porous electrode via a spacer. An electrolytic solution made of 0.6 mol/L of an anhydrous acetonitrile solution of lithium iodide and 0.06 mol/L of an anhydrous acetonitrile solution of iodine was injected between the electrodes, thereby preparing a photoelectric conversion element.

The specific surface area of the electrode film of Example 6 was measured by the BET method. The specific surface area was 91 m²/g, which was greater than that of the electrode film using only a titanium oxide-covered carbon material.

### Experimental Example 4

Each of the prepared photoelectric conversion elements having an area of 0.25 cm² was irradiated with light having an intensity of 100 mW/cm² under conditions of AM 1.5 (rank A as defined by JIS C8912), using a solar simulator manufactured by Yamashita Denso Corporation, and photoelectric conversion characteristics were evaluated.

The results are shown in Table 1.

**Table 1**

| Experiment No. | Titanium Oxide-Covered Carbon Material : Titanium Oxide Particles (wt%) | Photoelectric Conversion Efficiency (%) |
|---|---|---|
| Comp. Ex. 1 | 0:100 | 2.8 |
| Ex. 4 | 2:98 | 4.4 |
| Ex. 5 | 5:95 | 4.8 |
| Ex. 6 | 10:90 | 6.8 |
| Ex. 7 | 20:80 | 8.2 |
| Ex. 8 | 50:50 | 7.5 |
| Ex. 9 | 80:20 | 6.4 |
| Ex. 10 | 100:0 | 4.0 |

The samples of Examples 4 to 10 comprising porous titanium oxide-covered carbon materials of the invention exhibited photoelectric conversion efficiencies higher than those of the samples of Comparative Examples 1 and 2. Furthermore, the samples of Examples 4 to 9 comprising porous titanium oxide-covered carbon material compositions of the invention exhibited photoelectric conversion characteristics higher than that of the sample of Example 10 comprising a titanium oxide-covered carbon material of the invention alone. Compared to the sample of Example 9, the samples of Examples 4 to 8 also exhibited great ease of application of the compositions and high covering-film strengths, thus achieving reduced costs. The samples of Examples 4 to 8 were therefore found to be superior.

### Experimental Example 5

Measurement of the pore size distribution of the electrode film obtained in Comparative Example 1 using a specific surface area/pore size distribution measuring apparatus showed that the pore size distribution was mainly in the range of 3 to 6 nm, with a mode of 4 nm (5 to 50 nm pores: 12%).

Measurement of the pore size distribution of the electrode film obtained in Example 7 in the same manner showed that the pore size distribution was mainly in the range of 7 to 30 nm, with a mode of 15 nm (5 to 50 nm pores: 90%).

It is believed that the diffusion of ions of the electrolytic solution was inhibited in the sample of Comparative Example 1, whereas the diffusion of ions occurred smoothly in the sample of Example 7 having an appropriate pore size distribution, partly contributing to the improved photoelectric conversion efficiency.

Moreover, measurement of the pore size distribution of the electrode film obtained in Example 10 in the same manner showed that the pore size distribution was mainly in the range of 20 to 100 nm, with a mode of 70 nm (5 to 50 nm pores: 15%).

It is thus understood that the sample of Example 7, even when compared to the sample of Example 10, is excellent in both conductivity and diffusion of ions of the electrolytic solution.

### [Reference Signs List]

100: A TEM image of the lengthwise direction of a nanoflake carbon tube
110: Substantially linear graphene sheet images
200: A TEM image of a cross section substantially perpendicular to the lengthwise direction of a nanoflake carbon tube
210: Arc-shaped graphene sheet images
300: Linear graphene sheet images that are continuous over the entire length in the lengthwise direction of a nested multi-walled carbon nanotube
400: A TEM image of a cross section perpendicular to the lengthwise direction of a nested multi-walled carbon nanotube

## Claims

1. A rod-like or fibrous titanium oxide-covered carbon material comprising
(1a) rod-like or fibrous carbon, and
(1b) titanium oxide particles,
wherein a surface of the carbon (1a) is covered with a covering layer comprising the titanium oxide particles (1b) connected to one another.

2. The rod-like or fibrous titanium oxide-covered carbon material according to Claim 1, wherein 70 to 100% of the surface of the carbon (1a) is covered with the titanium oxide particles (1b), as measured by electron microscopic observation.

3. The rod-like or fibrous titanium oxide-covered carbon material according to Claim 1 or 2, wherein an element ratio (C/Ti) of carbon and titanium on the surface of the rod-like or fibrous titanium oxide-covered carbon material is 0/100 to 70/30 (atomic ratio), as measured by X-ray photoelectron spectroscopic analysis.

4. The rod-like or fibrous titanium oxide-covered carbon material according to any one of claims 1 to 3, wherein the rod-like or fibrous titanium oxide-covered carbon material has a powder resistance of 10 Ω·m or less at a pressure of 10 MPa.

5. The titanium oxide-covered carbon material according to any one of claims 1 to 4, wherein the titanium oxide-covered carbon material has a mean diameter of 5 to 500 nm perpendicular to a long axis, a mean long-axis length of 0.1 to 1,000 µm, and a mean aspect ratio of 3 to 200,000.

6. The titanium oxide-covered carbon material according to any one of claims 1 to 5, wherein the titanium oxide particles (1b) have a mean particle size of 1 to 200 nm.

7. The titanium oxide-covered carbon material according to any one of claims 1 to 6, wherein the covering layer has a thickness of 2 to 500 nm.

8. The titanium oxide-covered carbon material according to any one of claims 1 to 7, wherein the carbon (1a) has a mean diameter of 1 to 100 nm perpendicular to a long axis, a mean long-axis length of 0.1 to 1,000 µm, and a mean aspect ratio of 5 to 1,000,000.

9. The titanium oxide-covered carbon material according to any one of claims 1 to 8, wherein the titanium oxide-covered carbon material has a specific surface area of 50 m²/g or more.

10. The titanium oxide-covered carbon material according to any one of claims 1 to 9, wherein the rod-like or fibrous carbon (1a) is nanoscale carbon tubes.

11. The titanium oxide-covered carbon material according to any one of claims 1 to 10, wherein the titanium oxide particles (1b) comprise at least one member selected from the group consisting of anatase titanium oxide, rutile titanium oxide, and brookite titanium oxide.

12. A process for producing the titanium oxide-covered carbon material of any one of claims 1 to 11, comprising the step of
forming a covering layer comprising titanium oxide particles (1b) connected to one another on a surface of rod-like or fibrous carbon (1a) by performing a precipitation reaction from a fluorotitanate complex.

13. A porous titanium oxide-covered carbon material composition being a mixture of:
(1) the rod-like or fibrous titanium oxide-covered carbon material of any one of claims 1 to 11; and
(2) titanium oxide particles.

14. The porous titanium oxide-covered carbon material composition according to claim 13, wherein the mixture comprises 0.1 to 90 wt% of the titanium oxide-covered carbon material (1) and 10 to 99.9 wt% of the titanium oxide particles (2).

15. The porous titanium oxide-covered carbon material composition according to claim 13 or 14, wherein the titanium oxide particles (2) have a mean particle size of 1 to 500 nm.

16. The porous titanium oxide-covered carbon material composition according to any one of claims 13 to 15, wherein the porous titanium oxide-covered carbon material composition has a specific surface area of 30 m²/g or more.

17. The porous titanium oxide-covered carbon material composition according to any one of claims 13 to 16, wherein the titanium oxide particles (2) comprise at least one member selected from the group consisting of anatase titanium oxide, rutile titanium oxide, and brookite titanium oxide.

18. The porous titanium oxide-covered carbon material composition according to any one of claims 13 to 17, comprising 40 to 100% of pores having a pore size of 5 to 50 nm of a total volume of pores.

19. A process for producing the porous titanium oxide-covered carbon material composition of any one of claims 13 to 18, comprising the steps of:
(A) forming a covering layer comprising titanium oxide particles (1b) connected to one another on a surface of rod-like or fibrous carbon (1a) by performing a precipitation reaction from a fluorotitanate complex, thereby preparing a titanium oxide-covered carbon material (1); and
(B) mixing the titanium oxide-covered carbon material (1) obtained in Step (A) with titanium oxide particles (2).

20. A photoelectric conversion element comprising a dye deposited on a surface of an active material, the active material comprising the titanium oxide-covered carbon material of any one of claims 1 to 11, or the porous titanium oxide-covered carbon material composition of any one of claims 13 to 18.
